# FASCICULE DE BREVET EUROPEEN

(11) **EP 2 845 231 B1**
(45) Date de publication et mention de la délivrance du brevet: **06.04.2016**
(21) Numéro de dépôt: 13714967.0
(22) Date de dépôt: 11.04.2013
(51) Int. Cl.: H01L 27/146, H01L 27/148, H01L 29/765, H01L 27/105

(54) **CAPTEUR D'IMAGE MATRICIEL A TRANSFERT DE CHARGES BIDIRECTIONNEL A GRILLES DISSYMETRIQUES**
MATRIXBILDSENSOR FÜR BIDIREKTIONALE LADUNGSÜBERTRAGUNG MIT ASYMMETRISCHEN GATES
MATRIX IMAGE SENSOR PROVIDING BIDIRECTIONAL CHARGE TRANSFER WITH ASYMMETRIC GATES

(30) Priorité: 03.05.2012 FR 1254070
(43) Date de publication de la demande: 11.03.2015
(73) Titulaire: E2V Semiconductors, 38120 Saint Egrève (FR)
(72) Inventeur: MAYER, Frédéric, F-38500 Voiron (FR)
(74) Mandataire: Desvignes, Agnès
(86) Numéro de dépôt international: PCT/EP2013/057546
(87) Numéro de publication internationale: WO 2013/164169

(56) Documents cités:
- WO-A1-2011/144459
- US-A1- 2007 064 137
- US-B1- 6 465 820
- US-B1- 6 633 058

## Description

L'invention concerne les capteurs d'image, tout particulièrement les capteurs à défilement et intégration de signal (ou capteurs TDI, de l'anglais : Time Delay Integration Linear Sensors), dans lesquels une image d'une ligne de points d'une scène observée est reconstituée par addition d'images successives prises par plusieurs lignes photosensibles observant successivement une même ligne de la scène au fur et à mesure que la scène défile devant le capteur perpendiculairement aux lignes.

Ces capteurs sont utilisés par exemple dans des systèmes d'observation de la terre par satellite. Ils comprennent plusieurs lignes parallèles de pixels photosensibles ; le séquencement des circuits de commande des différentes lignes (contrôle de temps d'exposition puis de lecture des charges photogénérées) est synchronisé par rapport au défilement relatif de la scène et du capteur, de manière que toutes les lignes du capteur voient une seule ligne de la scène observée. Les signaux générés sont ensuite additionnés point à point pour chaque point de la ligne observée.

Le rapport signal/bruit théorique est amélioré dans le rapport de la racine carrée du nombre N de lignes du capteur. Ce nombre peut aller de quelques lignes à une centaine selon les applications (contrôle industriel, observation terrestre, radiographie panoramique dentaire ou mammographie).

De plus, les non-uniformités de sensibilité des pixels d'une même barrette, et les non-uniformités de courant d'obscurité des pixels, sont diminuées par suite du moyennage qui résulte de l'addition des signaux des différentes lignes.

Dans les capteurs d'image à transfert de charges (capteurs CCD), l'addition des signaux point par point se faisait naturellement et sans bruit de lecture en vidant dans une ligne de pixels les charges générées et accumulées dans la ligne de pixels précédente, en synchronisme avec le déplacement relatif de la scène et du capteur. La dernière ligne de pixels, ayant accumulé N fois les charges engendrées par la ligne d'image observée, peut être lue.

La technologie habituelle des capteurs d'image CCD utilise des tensions d'alimentation élevées et consomme une énergie importante ; cette technologie est basée sur l'utilisation de grilles de silicium polycristallin adjacentes et en recouvrement mutuel.

La technologie des capteurs d'image a ensuite évolué vers des capteurs à pixels actifs à transistors, qu'on appellera ci-après capteurs CMOS pour simplifier car ils sont en général réalisés en technologie CMOS (complementary-metal-oxyde-semiconducteur) ; dans ces capteurs CMOS il n'y a plus de transfert de charges de ligne en ligne vers un circuit de lecture ou un registre mais il y a des pixels actifs à transistors qui recueillent des charges électriques photogénérées et les convertissent directement en une tension ou un courant. Les différentes lignes du capteur fournissent donc successivement des tensions ou courants représentant l'éclairement reçu par la ligne. Ces structures ne permettent pas de réaliser des sommations sans bruit de ces courants ou tensions ; il est donc difficile de réaliser un capteur à défilement et à intégration de charges. La technologie de fabrication est cependant simple, elle consomme peu, et elle fonctionne sous basse tension.

Des tentatives ont cependant été faites pour réaliser des capteurs CMOS à défilement et intégration de charges.

On a essayé en particulier d'utiliser des capacités commutées dans lesquelles on intègre des courants successifs reçus, accumulant ainsi sur une même capacité des charges reçues de plusieurs pixels en colonne (US6906749, WO0126382).

On a également proposé de convertir en valeurs numériques les signaux issus d'une ligne de pixels, de sommer la valeur numérique correspondant au pixel de rang j de la ligne dans un registre accumulateur de rang j qui accumule les valeurs numériques correspondant aux pixels de même rang j de N lignes successives (brevet FR2906080).

Des solutions utilisant une accumulation de charges à l'intérieur du pixel ont également été proposées, par exemple dans la publication de brevet US2008/0217661. Elles utilisent une technologie plus complexe que celle qui est strictement nécessaire pour réaliser des capteurs d'image en technologie CMOS, ou bien elles présentent des pertes lors des transferts de charges.

Dans la publication de brevet FR2960341 on a proposé un capteur en technologie CMOS à un seul niveau de grille en silicium polycristallin, utilisant une alternance de grilles et de photodiodes. La structure repose sur une dissymétrie des grilles pour imposer une direction de transfert commune à toutes les charges, pour éviter que les charges ne partent aléatoirement dans une direction ou la direction inverse. Du fait de cette dissymétrie volontaire, il est exclu de pouvoir choisir un sens de transfert des charges dans le sens opposé au sens imposé par la dissymétrie. Or dans certaines applications, l'utilisateur souhaite pouvoir inverser le sens d'accumulation des charges. C'est le cas par exemple dans un scanner fonctionnant en mode TDI et devant pouvoir travailler avec deux sens de balayage opposés sans inversion de l'orientation du capteur par rapport à l'image.

Le document WO 2011/144459 décrit un capteur d'image matriciel à transfert de charges à grille dissymétrique.

L'invention a pour but de proposer une solution simple pour réaliser des capteurs fonctionnant selon le principe des structures à transfert de charges, utilisant une technologie compatible avec des circuits de technologie CMOS, notamment une technologie n'utilisant qu'un seul niveau de grille en silicium polycristallin pour les grilles de stockage ou de transfert de charges, et cependant permettant un choix du sens de transfert des charges.

Selon l'invention, on propose un capteur d'image à transfert de charges, le capteur comportant des lignes de photodiodes alternées avec des lignes de grilles adjacentes aux photodiodes, les grilles recouvrant une région de couche active d'un premier type de conductivité et les photodiodes étant formées dans la couche active par des régions individuelles d'un deuxième type de conductivité elles-mêmes recouvertes par des régions superficielles individuelles du premier type reliées à un potentiel de référence de la couche active, les grilles étant dissymétriques, adjacentes d'un côté à une photodiode et pourvue de l'autre côté de doigts de grille étroits en extension vers une autre photodiode, les doigts étroits étant séparés les uns des autres par des régions d'isolation dopées du premier type de conductivité, plus dopées que les régions superficielles, reliées comme elles au potentiel de référence de la couche active, le capteur étant caractérisé en ce qu'il comporte au moins deux grilles indépendantes adjacentes à la fois à une première photodiode appartenant à une première ligne de photodiodes et à une deuxième photodiode appartenant à une deuxième ligne de photodiodes, une première des deux grilles ayant ses doigts étroits en extension vers la première photodiode et la deuxième grille ayant ses doigts étroits en extension vers la deuxième photodiode, et les deux grilles étant commandables séparément l'une de l'autre.

Par grille "dissymétrique", on entend le fait qu'il y a une dissymétrie entre le côté amont (côté qui reçoit des charges) et le côté aval (côté qui fournit) des charges. Il peut y avoir une symétrie par rapport à un axe parallèle au sens de déplacement des charges.

Les doigts sont suffisamment étroits pour que le potentiel de la couche active sous ces doigts soit influencé par la présence des régions d'isolation dopées de part et d'autre des doigts, de manière que le potentiel sous les doigts soit localement plus faible que sous le corps principal de la grille malgré le fait que les doigts soient portés au même potentiel que le corps principal de la grille.

Par potentiel plus faible, on entend qu'une barrière de potentiel se crée dans la couche active sous les doigts par rapport au potentiel sous le corps principal. Cette notion de barrière de potentiel créée par un potentiel plus faible se réfère au fait que les charges stockées sont des électrons. On supposera en effet pour simplifier (et parce que c'est généralement ainsi dans la pratique) que la couche active est de type p, que les charges photogénérées sont des électrons et non des trous, et par conséquent qu'un potentiel plus bas constitue une barrière de potentiel pour les électrons par rapport à un potentiel plus haut.

Dans tout ce qui suit on considérera que le capteur est réalisé avec une couche active de type p, que les photodiodes stockent des électrons dans des régions individuelles de type n, et que les régions superficielles et les régions dopées qui séparent les doigts étroits sont de type p.

Les charges présentes à un moment donné sous une grille donnée portée à un potentiel bas ne peuvent pas s'écouler vers la photodiode située en amont, le côté amont étant le côté de la grille qui comporte des doigts ; en effet, elles ne peuvent pas s'écouler entre les doigts de la grille à cause de la présence des régions d'isolation, ni sous ces doigts à cause du potentiel induit sous les doigts par ces régions ; elles ne peuvent s'écouler que vers une photodiode en aval de la grille de stockage, par le côté de la grille qui ne comporte pas de doigts ; de ce côté, la grille est directement adjacente à la région superficielle p de la photodiode aval. Inversement, lorsqu'elle est portée à un potentiel haut, la grille peut recevoir des charges provenant de la photodiode située immédiatement en amont, à travers les doigts dont les extrémités sont directement adjacentes à la photodiode. Le côté amont et le côté aval sont inversés pour la première et la deuxième grille.

Le capteur comporte de préférence des moyens pour appliquer aux premières grilles une séquence de potentiels permettant le stockage et le transfert de charges sous les premières grilles, tout en maintenant à une valeur fixe pendant un cycle d'intégration de charges le potentiel des deuxièmes grilles, empêchant le stockage et le transfert de charges sous ces dernières, et des moyens pour inverser les rôles des premières et deuxièmes grilles, c'est-à-dire appliquer une séquence de potentiels aux deuxièmes grilles tout en maintenant à une valeur fixe le potentiel des premières grilles.

Le capteur peut fonctionner selon deux modes principaux.

Dans un premier mode, les grilles (et non les photodiodes) servent à stocker les charges pendant la durée d'intégration. Dans le cas d'un transfert de charges en deux phases, une grille sur deux dans le sens des colonnes de pixels (qui est le sens de transfert des charges) est alors maintenue à un potentiel élevé pendant une demi-période d'intégration, l'autre grille étant maintenue à un potentiel bas ; puis les rôles sont inversés pendant une deuxième demi-période d'intégration. Mais seules les grilles ayant leurs doigts étroits tournés vers l'amont subissent cette séquence. Celles qui ont leurs doigts étroits tournés vers l'aval restent à un potentiel bas empêchant qu'elles ne reçoivent ou qu'elles ne laissent passer des charges.

Dans un deuxième mode de réalisation, ce sont les photodiodes qui servent à stocker les charges pendant la durée d'intégration ; les grilles sont maintenues à un potentiel bas pendant la durée d'intégration et ne peuvent pas stocker ou laisser passer de charges. Les charges stockées dans les photodiodes sont transférées par une impulsion positive brève appliquée à certaines lignes de grille à la fin de chaque demi-période d'intégration (dans le cas d'un transfert de charges en deux phases). Cette impulsion est appliquée à une grille sur deux dans le sens des colonnes (sens du transfert des charges) et le rôle des grilles est inversé à chaque demi-période d'intégration. Là encore, seules les grilles ayant leurs doigts étroits tournés vers l'amont reçoivent cette séquence de potentiels. Celles qui ont leurs doigts étroits tournés vers l'aval restent à un potentiel bas empêchant qu'elles ne reçoivent ou laissent passer des charges.

Les deux grilles dissymétriques sont de préférence placées côte à côte dans la direction des lignes de telle sorte que les photodiodes s'étendent sur toute la longueur des deux grilles dans cette direction.

La deuxième grille peut être divisée en deux parties placées géométriquement de part et d'autre de la première grille et reliées électriquement l'une à l'autre pour être commandées simultanément.

On peut prévoir alternativement que chacune des deux grilles est divisée en au moins deux parties alternées avec les parties de l'autre grille, chaque partie comportant au moins un doigt étroit et les parties d'une même grille étant reliées électriquement les unes aux autres.

De préférence, la surface d'une photodiode d'une ligne de photodiodes adjacentes à une ligne de grilles est supérieure à la surface des deux grilles de cette ligne qui sont adjacentes à la photodiode. Dans ce cas, les photodiodes stockent les charges pendant les durées d'intégration et le stockage sous les grilles ne se produit que pendant des impulsions de transfert brèves appliquées aux grilles.

Le capteur peut comporter de préférence une microlentille rectangulaire respective (ou deux ou plusieurs microlentilles carrées) centrée sur chacune des photodiodes et dirigeant vers la photodiode la lumière reçue au-dessus d'une partie des grilles adjacentes à la photodiode.

Le capteur d'image est un capteur multilinéaire à défilement et intégration de charges (capteur TDI) en vue d'une observation d'une même ligne d'image successivement par plusieurs lignes de pixels avec une sommation des charges électriques générées par un point d'image dans les pixels de même rang des différentes lignes, les charges générées par l'éclairement d'un pixel de rang i pendant une durée d'intégration s'additionnant aux charges reçues du pixel de rang précédent ou suivant au début de cette durée.

D'autres caractéristiques et avantages de l'invention apparaîtront à la lecture de la description détaillée qui suit et qui est faite en référence aux dessins annexés dans lesquels :
- la figure 1 représente la structure générale d'un capteur d'image matriciel à transfert de charges ;
- la figure 2 représente en vue de dessus la constitution selon l'invention d'une colonne de pixels, sous forme d'une alternance de grilles et de photodiodes adjacentes aux grilles ;
- les figures 3 et 4 représentent des coupes verticales selon les lignes III-III et IV-IV de la figure 2 ;
- la figure 5 représente un diagramme de potentiels successifs dans le semiconducteur ;
- la figure 6 et la figure 7 représentent des variantes de réalisation des grilles ;
- la figure 8 et la figure 9 représentent la colonne de pixels avec des microlentilles disposées au-dessus de chaque photodiode.

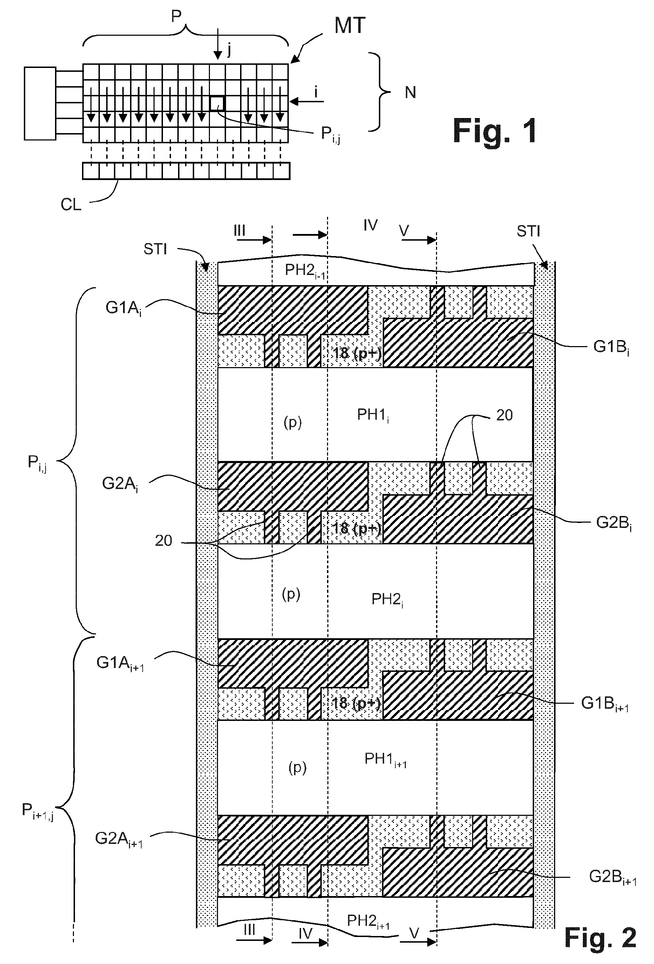

Sur la figure 1, on voit l'architecture générale d'un capteur d'image à transfert de charges. Le capteur comporte une matrice MT de N lignes de P pixels sensibles à la lumière. Les charges résultant de l'éclairement d'un pixel P_{i,j} de rang i en ligne et j en colonne sont intégrées dans le pixel pendant une durée d'intégration Tᵢₙₜ ; puis elles sont transférées dans le pixel de la ligne suivante de rang i+1 en ligne et de même rang j en colonne ; les pixels adjacents dans le sens des colonnes (sens vertical sur la figure) sont agencés en registre à décalage vertical à transfert de charges.

Le capteur peut être un capteur matriciel fournissant des images successives de NxP points d'image ou un capteur multilinéaire TDI fournissant des images linéaires de P points, vues et accumulées par les N lignes de pixels.

Dans les deux cas, les pixels en colonne se comportent comme des registres à décalage verticaux mais c'est dans le deuxième cas seulement qu'on accumule dans chaque pixel d'une part les charges photogénérées dans ce pixel pendant une durée d'intégration Tᵢₙₜ et d'autre part les charges provenant d'un pixel précédent.

Si le capteur est un capteur linéaire à défilement et intégration de charges, on ne lit pas les charges contenues dans les NxP pixels après chaque durée d'intégration Tᵢₙₜ, mais on accumule les charges lues par les N pixels d'une colonne pendant N durées d'intégration successives, en synchronisme avec le défilement de l'image devant le capteur. Chacune des N lignes de pixels voit successivement une même ligne d'image au cours du défilement de l'image par rapport au capteur ; les charges intégrées dans une ligne de rang i, qui correspondent à une ligne d'image observée, sont additionnées dans les pixels de cette ligne aux charges précédemment lues par les i-1 lignes précédentes qui ont vu la même ligne d'image pendant les durées d'intégration précédentes. Au bout de N durées d'intégration, la dernière ligne de pixels contient la somme des charges recueillies par toutes les lignes qui ont vu la même ligne d'image. Cette ligne est lue à la fin de chaque durée Tᵢₙₜ par un circuit de lecture CL comprenant des circuits d'échantillonnage au pied de chaque colonne, suivis par un ou plusieurs circuit de conversion analogique-numérique (en technologie CMOS).

La vue de dessus de la figure 2 représente la structure d'une colonne de pixels selon l'invention. Deux pixels adjacents P_{i,j} et P_{i+1,j} sont représentés. Dans une configuration avec un transfert de charges en deux phases, chaque pixel comprend
- deux photodiodes,
- des grilles situées entre les deux photodiodes et adjacentes aux deux photodiodes,
- et des grilles situées entre une photodiode et la photodiode la plus proche du pixel précédent ou suivant, ces grilles étant adjacentes à ces deux photodiodes.

Le transfert de charges pourrait également se faire en trois ou même quatre phases, et dans ce cas il y aurait respectivement trois ou quatre photodiodes par pixel : pour chaque phase, une photodiode et des grilles adjacentes à un côté de cette photodiode.

On décrira l'invention plus précisément dans le cas d'un transfert en deux phases, le principe étant le même pour un transfert en trois ou quatre phases.

Dans l'exemple représenté sur la figure 2, on considère donc que le pixel P_{i,j} comprend une première photodiode PH1ᵢ, une deuxième photodiode PH2ᵢ, des grilles G2Aᵢ et G2Bᵢ situées entre les deux photodiodes, et des grilles G1Aᵢ et G1Bᵢ situées entre la première photodiode PH1ᵢ du pixel et la deuxième photodiode PH2ᵢ₋₁ du pixel précédent de rang i-1.

La deuxième photodiode PH2ᵢ est par ailleurs adjacente à deux grilles G1Aᵢ₊₁ et G1 Bᵢ₊₁ qui font partie du pixel suivant et qui sont adjacentes aussi à la première photodiode PH1ᵢ₊₁ de ce pixel suivant. Et enfin, pour le pixel P_{i+1,j} il y a une autre photodiode PH2ᵢ₊₁ et des grilles G2Aᵢ₊₁ et G2Bᵢ₊₁ adjacentes à la fois à la photodiode PH1ᵢ₊₁ et à la photodiode PH2ᵢ₊₁.

La matrice de pixels est ainsi constituée par une alternance de lignes de photodiodes et de lignes de grilles situées entre deux lignes de photodiodes. Les grilles sont adjacentes aux photodiodes des deux lignes ; dans une même ligne de grilles il y a, pour chaque photodiode, deux grilles distinctes (par exemple G1Aᵢ, et G1Bᵢ) commandées indépendamment l'une de l'autre. Si la ligne comporte P pixels, il y a 2P grilles dans chaque ligne de grilles.

Comme on le voit sur la vue de dessus de la figure 2, la forme de la grille est dissymétrique. Si on prend par exemple la grille G2Bᵢ, un côté de la grille est adjacent sur toute sa longueur à une première photodiode (PH1ᵢ). L'autre côté est adjacent à une deuxième photodiode (PH2i) mais seulement par l'extrémité de doigts de grille étroits 20 en extension vers la deuxième photodiode. Le reste de la grille est séparé de la deuxième photodiode par une région semiconductrice 18, fortement dopée de type p (le dopage fort étant symbolisé par l'appellation p+).

L'expression "doigt étroit" signifie ici que la largeur des doigts est suffisamment faible pour que le potentiel dans le semiconducteur sous ces doigts soit influencé par le potentiel de la région 18 et pas seulement par le potentiel appliqué à la grille. Le potentiel sous la grille en dehors des doigts étroits n'est pas influencé par le potentiel de la région 18 mais il est défini seulement par le potentiel appliqué à la grille.

Selon l'invention, une des deux grilles situées entre une première photodiode (par exemple PH1ᵢ) et une deuxième photodiode (par exemple PH2ᵢ) possède des doigts étroits tournés vers la première photodiode, mais l'autre grille possède des doigts étroits tournés vers la deuxième photodiode. Ici, G2Bᵢ a ses doigts étroits tournés vers la première photodiode, et G2Aᵢ a ses doigts tournés vers la deuxième photodiode.

Le fonctionnement est le suivant : si on veut transférer les charges du haut de la figure vers le bas de la figure, donc des premières diodes PH1ᵢ ou PH1ᵢ₊₁ vers les deuxièmes diodes PH2ᵢ, PH2ᵢ₊₁, on désactive toutes les grilles de gauche (G1Aᵢ, G2Aᵢ, G1Aᵢ₊₁, G2Aᵢ₊₁) en maintenant leur potentiel à une valeur basse, et on active les grilles de droite selon une séquence permettant un transfert de charges. Cette séquence consiste à alterner les potentiels des grilles entre une valeur basse (potentiel bas 0 volt de l'alimentation) et une valeur haute (potentiel haut Vdd de l'alimentation). On décrira plus précisément cette séquence plus loin.

Toutes les grilles G1 B sont connectées entre elles pour recevoir alternativement ce potentiel bas et ce potentiel haut à la fin d'une première demi-période d'intégration. De même, toutes les grilles G2B sont connectées entre elles pour recevoir une impulsion de transfert à la fin d'une deuxième demi-période d'intégration.

Pour transférer les charges dans l'autre sens, on utilise une alternance de potentiels sur les grilles de gauche (GA) et on neutralise les grilles de droite (GB) en maintenant leur potentiel à une valeur basse. Les grilles G1A sont connectées entre elles, mais indépendantes des grilles G1 B. De même, les grilles G2A sont connectées entre elles mais indépendantes des grilles G2B.

Le transfert de charges s'effectue donc d'un sens amont vers un sens aval à travers les grilles qui ont leurs doigts tournés vers l'amont. Si on choisit un sens de transfert donné, on doit donc utiliser les grilles qui ont leurs doigts tournés vers l'amont et neutraliser celles qui ont leurs doigts tournés vers l'aval.

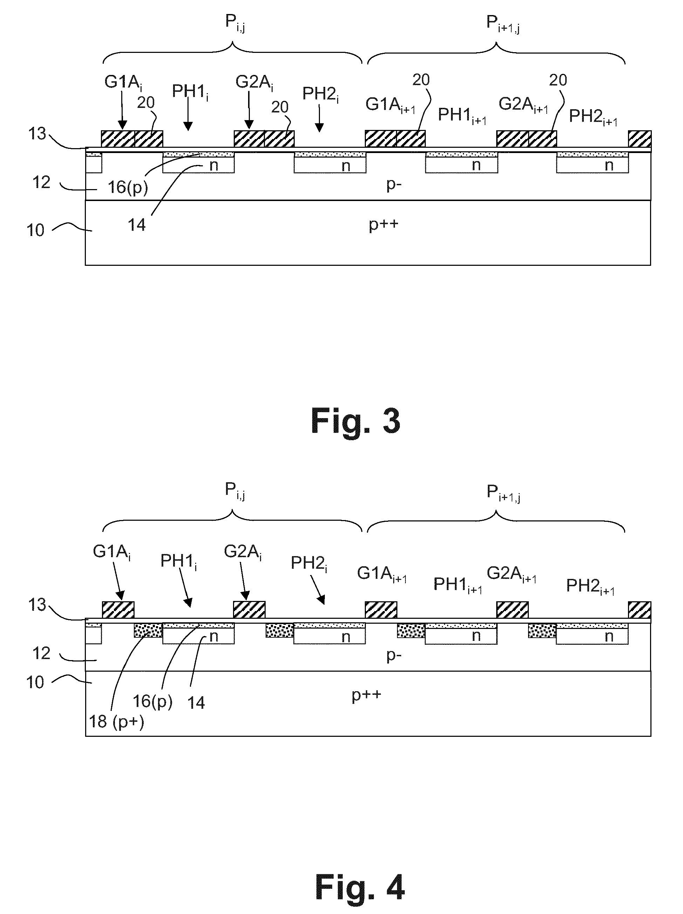

La figure 3 et la figure 4 représentent des vues en coupe de la structure du capteur. La coupe de la figure 3 est une coupe selon la ligne III-III de la figure 2, à travers les doigts étroits 20. La coupe de la figure 4 est une coupe selon la ligne IV-IV de la figure 2, là où il n'y a pas de doigts mais une région p+18 entre la grille et une photodiode.

Les pixels sont formés dans un substrat semiconducteur 10 dont la partie supérieure est une couche active semiconductrice épitaxiale peu dopée 12. Dans cet exemple, le substrat est de type p++ fortement dopé, et la couche active épitaxiale est de type p-. Si la couche épitaxiale était de type n, il faudrait inverser tous les types de conductivité, ainsi que les signes des potentiels appliqués aux photodiodes et aux grilles. Le substrat est en principe de même type de conductivité que la couche épitaxiale, mais il pourrait également être de type opposé.

Les grilles sont des grilles de silicium polycristallin, isolées de la couche épitaxiale 12 par une fine couche isolante 13 (oxyde ou nitrure de silicium). Les photodiodes sont des photodiodes de type "pinned", c'est-à-dire qu'elles sont réalisées par un empilement comprenant : la couche épitaxiale 12 de type p (couche active commune pour toutes les photodiodes de tous les pixels), une région individuelle 14 de type n diffusée dans la couche épitaxiale entre deux grilles de transfert, et une région superficielle individuelle 16 de type p, plus dopée que la couche épitaxiale, recouvrant la région individuelle 14 et maintenue à un potentiel fixe. Les électrons générés par l'éclairement pourront s'accumuler dans des puits de potentiel formés à la jonction entre la région n et la couche épitaxiale p.

Les régions 18, dopées de type P+, visibles seulement sur la figure 4, sont plus dopées que les régions superficielles 16. Elles sont portées à un potentiel de référence bas qui est le potentiel de la couche active 12. Elles sont adjacentes aux régions superficielles et portent le potentiel des régions superficielles à ce potentiel.

Si les régions superficielles 16 sont très peu profondes comme on le souhaite pour améliorer la sensibilité dans le bleu, alors les régions 18 sont de préférence plus profondes que les régions 16.

Les colonnes de pixel sont séparées par des zones d'isolation STI (oxyde de silicium ou autre) qui empêchent tout transfert de charges entre pixels de colonnes différentes.

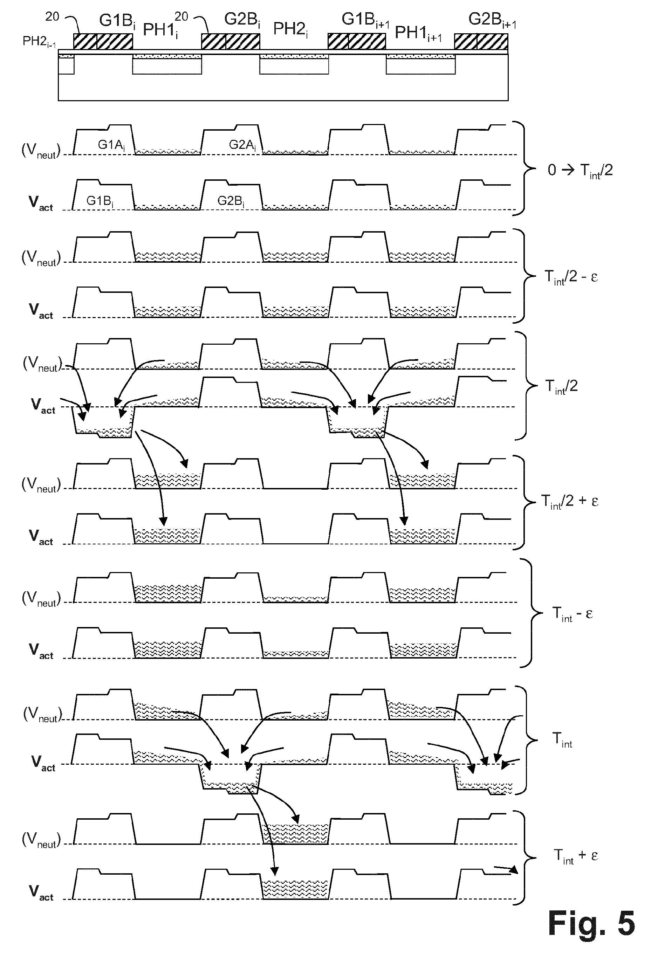

La figure 5 représente un diagramme de potentiels à l'intérieur de la couche active, à une profondeur où se situe le stockage et le transfert de charges, c'est-à-dire légèrement au-dessous de la surface supérieure de la couche active.

Les potentiels sont représentés au cours des différentes phases de fonctionnement et prennent en compte le fait que le potentiel sous les doigts étroits pour un potentiel donné appliqué à la grille n'est pas le même que le potentiel sous le reste de la grille en raison justement de l'étroitesse du doigt. Plus précisément, pour un potentiel donné appliqué à la grille et donc appliqué aussi aux doigts étroits de la grille, l'influence exercée par le potentiel bas des régions p+ 18 qui entourent le doigt étroit tend à abaisser le potentiel dans le semiconducteur sous les doigts étroits par rapport au potentiel dans le semiconducteur sous le reste de la grille, sans toutefois l'abaisser autant que dans les régions p+. Conformément à la convention habituelle, les potentiels croissants sont dirigés vers le bas pour bien faire apparaître les puits de potentiel et les barrières de potentiel pour les électrons.

Les diagrammes de potentiel représentés correspondent aux variations de potentiels le long de la ligne de coupe V-V de la figure 2, la coupe V-V étant représentée au-dessus de ces diagrammes pour faciliter la compréhension.

Deux modes de fonctionnement sont possibles :
- un mode dans lequel les charges s'accumulent sous les grilles pendant les durées d'intégration ; dans ce cas, un potentiel haut est appliqué à une grille sur deux dans le sens des colonnes (sens du transfert des charges) pendant une première demi-période d'intégration, ce potentiel haut créant un puits de potentiel sous la grille concernée ; les autres grilles reçoivent un potentiel bas ; à la fin de la première demi-période d'intégration on inverse les rôles des grilles : celles qui avaient un potentiel haut reçoivent un potentiel bas et réciproquement. Seules sont concernées par cette séquence les grilles ayant leur doigts étroits tournés vers l'amont. Les autres reçoivent un potentiel fixe bas et ne peuvent ni recevoir de charges ni laisser passer de charges ;
- un mode dans lequel les charges s'accumulent dans les photodiodes et non pas sous les grilles pendant les durées d'intégration ; les grilles ne stockent des charges que temporairement pendant une brève opération de transfert.

La figure 5 correspond au deuxième mode, et elle correspond à un fonctionnement en deux phases, ce qui veut dire que chaque pixel de forme à peu près carrée comporte deux photodiodes, et que la durée d'intégration est décomposée en deux demi-périodes d'intégration avec un transfert de charges partiel après chaque demi-période. On rappelle que le capteur pourrait fonctionner en trois ou quatre phases avec des pixels de forme à peu près carrée comprenant trois ou quatre photodiodes.

La figure 5 correspond à un transfert de charges du haut vers le bas de la figure 2, c'est-à-dire qu'on utilise activement les grilles de droite G1B, G2B pour effectuer les transferts à travers ces grilles et on neutralise les grilles de gauche G1A, G2A.

Pour chaque étape du diagramme, on a représenté les potentiels de la voie active V_{act} mais aussi les potentiels de la voie neutralisée Vₙₑᵤₜ (qui ne varient pas dans le temps mais qui jouent un rôle pour interdire le passage de charges sous les grilles neutralisées).

Toutes les grilles neutralisées G1A, G2A restent à un potentiel bas pendant tous les cycles d'intégration et transfert de charges. Aucun stockage ou transfert de charges ne peut se faire sous ces grilles.

Le potentiel du semiconducteur dans les photodiodes supposées vides de charges a une valeur fixée par le fait que la couche superficielle de type p est maintenue au potentiel de référence de la couche active. Ce potentiel de base de la photodiode à vide est représenté par une ligne tiretée. Il dépend des profils de dopage des régions 12, 14, 16 dans la photodiode.

Les potentiels varient au cours d'une durée d'intégration Tᵢₙₜ décomposée en deux phases de durée Tᵢₙₜ/2.

Le premier groupe de deux lignes du diagramme de la figure 5 représente les potentiels internes de la couche active pendant une première demi-durée d'intégration allant d'un instant initial 0 à un instant Tint/2. Toutes les grilles G1B, G2B sont à un potentiel bas (comme les grilles G1A, G2A) et les charges s'accumulent progressivement sous l'effet de la lumière dans les puits de potentiel formés sous toutes les photodiodes. Ces puits sont fermés par les potentiels bas appliqués aux grilles actives et aux grilles neutralisées. Ils sont fermés également par les régions p+ 18 qui forment une barrière de potentiel encore plus haute que la barrière formée sous les grilles. Et enfin, ils sont fermés par les zones d'isolation STI qui séparent les colonnes de pixels les unes des autres.

Le deuxième groupe de lignes du diagramme représente les potentiels internes à un temps Tᵢₙₜ/2 - ε, c'est-à-dire juste avant la fin de la première demi-période d'intégration Tᵢₙₜ/2. Les photodiodes ont acquis toutes les charges générées par l'éclairement pendant cette durée.

Le troisième groupe de lignes représente l'instant d'application d'une impulsion brève de transfert à une grille active sur deux. Ici, les grilles G1B (G1Bᵢ, G1Bᵢ₊₁, etc.) reçoivent toutes cette impulsion de transfert mais pas les grilles G2B (G2Bᵢ, G2Bᵢ₊₁).

L'impulsion de transfert est à un potentiel haut créant un puits de potentiel sous les grilles qui la reçoivent. Les charges accumulées dans les photodiodes viennent se stocker sous les grilles qui leurs sont adjacentes. Cela veut dire que la grille G1Bᵢ reçoit les charges de la photodiode PH1ᵢ mais aussi (à travers ses doigts étroits) les charges de la photodiode PH2ᵢ₋₁ du pixel situé immédiatement en amont. De même, la grille G1Bᵢ₊₁ reçoit les charges de la photodiode PH2ᵢ et les charges de la photodiode PH1ᵢ₊₁ du pixel situé immédiatement en aval.

Le quatrième groupe de lignes représente l'état des potentiels à l'instant Tᵢₙₜ + ε, c'est-à-dire immédiatement après la fin de l'impulsion brève de transfert. Le potentiel sous les grilles G1 B redescend à son niveau bas de départ. Les charges stockées sous les grilles G1B se déversent dans la photodiode adjacente du côté aval. Elles ne vont pas vers la photodiode amont car elles ne pourraient passer que sous les doigts étroits (les régions p+ 18 formant une barrière) mais le potentiel sous les doigts étroits est plus bas que le reste du potentiel sous la grille et les charges sont naturellement orientées vers l'aval. Seules les photodiodes PH1 (PH1ᵢ, PH1ᵢ₊₁) reçoivent donc des charges. Les photodiodes PH2 restent vides.

Le cinquième groupe de lignes représente la fin de la deuxième demi-période d'intégration, à un instant Tᵢₙₜ - ε précédant immédiatement une nouvelle impulsion de transfert. La photodiode PH2ᵢ s'est remplie de charges résultant de l'éclairement de cette photodiode pendant la deuxième demi-période d'intégration, mais la photodiode PH1ᵢ est remplie à la fois des charges résultant de l'éclairement du pixel pendant cette demi-période et des charges transférées lors de l'impulsion de transfert précédente en provenance des photodiodes PH1ᵢ et PH2ᵢ₋₁.

Le sixième groupe de lignes représente l'état des potentiels pendant une deuxième impulsion de transfert brève à l'instant Tᵢₙₜ. Le potentiel des grilles G2B est porté au niveau haut pour créer des puits de potentiel sous ces grilles. Le potentiel des grilles G1 B ne bouge pas. Les charges des photodiodes PH1ᵢ et PH2ᵢ adjacentes à la grille G2Bᵢ se déplacent sous la grille G2Bᵢ.

Enfin, le septième groupe de lignes représente l'état final des potentiels à l'instant Tᵢₙₜ + ε, à la fin de l'impulsion brève de transfert. Le potentiel des grilles G2B est ramené à l'état bas. Les charges repassent dans les photodiodes mais de manière unilatérale dans le sens de l'amont vers l'aval en raison de la barrière de potentiel plus haute sous les doigts étroits et plus basse sous le reste de la grille. Les photodiodes PH2 se remplissent des charges stockées provisoirement sous la grille G2B. Les photodiodes PH1 restent vides.

Cet état final constitue l'état initial d'une nouvelle période d'intégration. Les charges contenues dans les photodiodes PH2ᵢ sont la somme des charges précédemment contenues (à l'instant 0) dans la photodiode PH2ᵢ₋₁, des charges engendrées par les photodiodes PH2ᵢ₋₁ et PH1ᵢ dans la première demi-période d'intégration, et des charges engendrées par les photodiodes PH1ᵢ et PH2ᵢ pendant la deuxième demi-période d'intégration. Les photodiodes PH1 (PH1ᵢ et PH1ᵢ₊₁) sont dépourvues de charges dans cet état initial.

Le sens de transfert global des charges va de la gauche vers la droite, c'est-à-dire que les charges accumulées dans la deuxième photodiode PH2ᵢ₋₁ d'un pixel amont au début d'une période d'intégration Tᵢₙₜ se retrouvent dans la deuxième photodiode PH2ᵢ du pixel suivant au début de la période d'intégration suivante avec des charges engendrées pendant la durée Tᵢₙₜ. On a donc bien à la fois un transfert unidirectionnel des charges vers la droite, et une sommation des charges accumulées dans un pixel précédent avec les charges générées dans le pixel courant, ce qui donne un fonctionnement de type TDI.

En inversant les rôles des grilles GA et GB et en conservant la même chronologie de signaux, on inverse le sens de transfert.

Les simulations effectuées montrent que la hauteur de la barrière de potentiel BP1ᵢ, BP2ᵢ, varie fortement avec la largeur des doigts étroits 20 ; typiquement elle peut varier de 0,5 volt à 2,5 volts pour des largeurs de doigts variant de 0,7 micromètre à 0,1 micromètre ; ces valeurs sont indicatives car elles dépendent de la technologie de gravure et des niveaux d'implantation utilisés. Une largeur de doigts inférieure ou égale à 0,4 micromètre est bien adaptée. La longueur des doigts dans le sens du transfert peut être de l'ordre de 0,4 micromètre.

On notera que les extrémités des doigts d'une même grille pourraient être reliées entre elles par une bande étroite de grille.

Les charges se déversent en bout de colonne de préférence dans une série de noeuds de stockage de charges et de circuits de conversion charge-tension (un noeud de stockage de charges et un circuit de conversion étant associés à chaque colonne de la matrice). Le circuit de conversion comprend quelques transistors, analogues aux transistors d'un pixel actif de capteur de technologie CMOS, parmi lesquels un transistor suiveur et un transistor de réinitialisation. Le circuit de conversion est alors de préférence associé à un circuit de double échantillonnage corrélé qui échantillonne d'abord un niveau de potentiel de réinitialisation au moment de la réinitialisation du potentiel du noeud de stockage de charges, puis un niveau de signal utile après déversement de charges de la dernière ligne de la matrice dans les noeuds de stockage de charges. La différence des deux échantillons est convertie par un convertisseur analogique-numérique. Un convertisseur élémentaire peut être prévu pour chaque colonne de pixels ou bien un convertisseur global effectue séquentiellement la conversion pour chacune des colonnes.

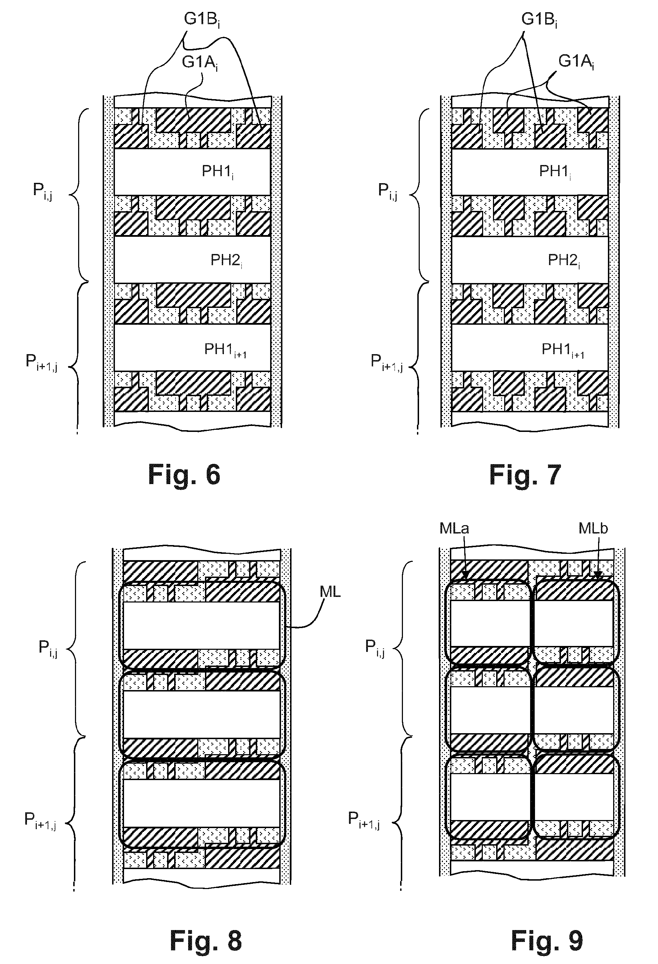

La figure 6 représente une variante de réalisation des grilles : parmi les deux grilles associées à un pixel et faisant partie de la même ligne de grilles, on prévoit que l'une des grilles (G1 B) est divisée en deux parties reliées électriquement l'une à l'autre par un conducteur non représenté, et ces deux parties sont disposées de part et d'autre de l'autre grille (G1 A).

La figure 7 représente une autre variante dans laquelle les deux grilles G1A et G1B sont divisées en au moins deux parties et les parties de l'une des grilles sont alternées géométriquement avec les parties de l'autre grille. Chaque partie comporte au moins un doigt étroit, tourné vers l'une ou l'autre photodiode selon qu'il s'agit d'une partie de grille GA ou d'une partie de grille GB.

Quelle que soit la constitution des grilles, il existe un risque de détérioration de la fonction de transfert de modulation géométrique en raison du fait qu'un électron généré dans le semiconducteur sous les grilles (les grilles sont transparentes) va se diriger naturellement vers l'une ou l'autre des photodiodes adjacentes à la grille. Selon que cette captation a lieu pendant l'une ou l'autre des demi-périodes d'intégration, cela a une conséquence négative ou non sur la FTM.

Ainsi par exemple :
- un électron engendré sous la grille G2Bᵢ pendant la deuxième demi-période d'intégration se dirige normalement vers la photodiode PHi₂ ; lors de l'impulsion de transfert qui suit, il est dirigé vers la grille G2Bᵢ puis vers la photodiode PH2ᵢ ;
- un électron engendré au même moment sous la grille G2Aᵢ se dirige normalement vers la photodiode PH1ᵢ ; lors de l'impulsion de transfert qui suit il est aussi dirigé vers la grille G2Bᵢ puis vers la photodiode PH2ᵢ.

Il n'y a pas dans ce cas de différence de traitement de l'électron selon qu'il est engendré sous la grille G2Aᵢ ou la grille G2Bᵢ et c'est une bonne chose.

Mais :
- un électron engendré sous la grille G2Bᵢ pendant la première demi-période d'intégration se dirige normalement vers la photodiode PHi₂ ; lors de l'impulsion de transfert qui suit, il est dirigé vers la grille G1 Bᵢ₊₁ puis vers la photodiode PH1ᵢ₊₁ ;
- inversement, un électron engendré au même moment sous la grille G2Aᵢ se dirige normalement vers la photodiode PH1ᵢ ; lors de l'impulsion de transfert qui suit il repart en arrière vers la grille G1Bᵢ puis vers la photodiode PH1ᵢ.

Il y a donc divergence de traitement selon que l'électron est engendré sous la grille G2Bᵢ ou sous la grille G2Aᵢ ; cette divergence détériore la fonction de transfert de modulation en mélangeant les électrons issus d'un pixel avec ceux d'un autre.

Pour éviter cette détérioration, on propose de recouvrir chaque demi-pixel d'une microlentille de focalisation qui concentre sur la photodiode la lumière reçue au-dessus de la surface d'un demi-pixel. Ainsi, les électrons seront systématiquement engendrés dans la photodiode et non sous les grilles.

Dans la réalisation de la figure 8, la microlentille ML est de forme rectangulaire et est centrée sur la photodiode. Elle recouvre toute la photodiode ainsi que la moitié de la surface des grilles situées de part et d'autre de la photodiode. Deux microlentilles adjacentes, recouvrant deux demi-pixels respectifs recouvrent une forme à peu près carrée correspondant à un pixel entier.

Dans la réalisation de la figure 9, on prévoit deux microlentilles carrées adjacentes en ligne MLa et MLb à la place de la microlentille rectangulaire. Chaque microlentille est centrée sur la moitié d'une photodiode et recouvre cette moitié de photodiode et la moitié des grilles adjacentes à cette moitié de photodiode. Quatre microlentilles adjacentes carrées recouvrent une surface à peu près carrée correspondant à un pixel entier.

## Revendications

1. Capteur d'image à transfert de charges, le capteur comportant des lignes de photodiodes alternées avec des lignes de grilles adjacentes aux photodiodes, les grilles recouvrant une région de couche active semiconductrice (12) d'un premier type de conductivité et les photodiodes étant formées dans la couche active par des régions individuelles d'un deuxième type de conductivité (14) elles-mêmes recouvertes par des régions superficielles individuelles du premier type (16) reliées à un potentiel de référence de la couche active, les grilles présentant une dissymétrie entre un côté amont et un côté aval, adjacentes d'un côté à une photodiode et pourvues de l'autre côté de doigts de grille étroits (20) en extension vers une autre photodiode, les doigts étroits étant séparés les uns des autres par des régions d'isolation (18) dopées du premier type de conductivité, plus dopées que les régions superficielles, reliées comme elles au potentiel de référence de la couche active, le capteur étant **caractérisé en ce qu'**il comporte au moins deux grilles indépendantes (G2Aᵢ, G2Bᵢ), adjacentes à la fois à une première photodiode (PH1ᵢ) appartenant à une première ligne de photodiodes et à une deuxième photodiode (PH2ᵢ) appartenant à une deuxième ligne de photodiodes, une première des deux grilles ayant ses doigts étroits en extension vers la première photodiode et la deuxième grille ayant ses doigts étroits en extension vers la deuxième photodiode, et les deux grilles étant commandables séparément l'une de l'autre.

2. Capteur selon la revendication 1, **caractérisé en ce qu'**il comporte des moyens pour appliquer aux premières grilles une séquence de potentiels permettant le stockage et le transfert de charges sous les premières grilles, tout en maintenant à une valeur fixe pendant un cycle d'intégration de charges le potentiel des deuxièmes grilles, empêchant le stockage et le transfert de charges sous les deuxièmes grilles, et des moyens pour inverser les rôles des premières et deuxièmes grilles, c'est-à-dire appliquer une séquence de potentiels aux deuxièmes grilles tout en maintenant à une valeur fixe le potentiel des premières grilles.

3. Capteur selon la revendication 2, **caractérisé en ce que** la séquence de potentiels appliqués à une première ou une deuxième grille comprend l'application d'un potentiel interdisant le stockage de charges sous la grille pendant une première durée d'intégration (Tᵢₙₜ/2) puis l'application à certaines lignes de grilles d'une impulsion brève créant sous ces grilles un puits de potentiel autorisant le déversement de charges depuis les photodiodes adjacentes à la grille jusque sous la grille.

4. Capteur selon l'une des revendications 1 à 3, **caractérisé en ce que** les deux grilles dissymétriques sont placées côte à côte dans la direction des lignes.

5. Capteur selon l'une des revendications 1 à 4, **caractérisé en ce que** la deuxième grille est divisée en deux parties placées géométriquement de part et d'autre de la première grille et reliées électriquement l'une à l'autre pour être commandées simultanément.

6. Capteur selon la revendication 5, **caractérisé en ce que** chacune des deux grilles est divisée en au moins deux parties alternées avec les parties de l'autre grille, les parties d'une grille étant reliées électriquement les unes aux autres, chaque partie comportant au moins un doigt étroit.

7. Capteur d'image selon l'une des revendications 1 à 6, **caractérisé en ce qu'**il est un capteur à défilement et intégration de charges, en vue d'une observation d'une même ligne d'image successivement par plusieurs lignes de pixels avec une sommation des charges électriques générées par un point d'image dans les pixels de même rang des différentes lignes, les charges générées par l'éclairement d'un pixel de rang i pendant une durée d'intégration s'additionnant aux charges reçues du pixel de rang précédent ou suivant au début de cette durée.

8. Capteur d'image selon l'une des revendications 1 à 7, **caractérisé en ce qu'**il comporte une microlentille rectangulaire respective centrée sur chacune des photodiodes et dirigeant vers la photodiode la lumière reçue au-dessus d'une partie des grilles adjacentes à la photodiode.

9. Capteur d'image selon l'une des revendications 1 à 7, **caractérisé en ce qu'**il comporte, au-dessus de chaque photodiode, au moins deux microlentilles carrées juxtaposées formant un ensemble centré au-dessus de la photodiode et dirigeant vers la photodiode la lumière reçue au-dessus de la photodiode et au-dessus d'une partie des grilles adjacentes à la photodiode.

## Patentansprüche

1. Bildsensor mit Ladungsübertragung, wobei der Sensor Fotodiodenleitungen umfasst, die mit Gitterleitungen neben den Fotodioden abwechseln, wobei die Gitter eine aktive Halbleiterschichtregion (12) eines ersten Leitfähigkeitstyps bedecken und die Fotodioden in der aktiven Schicht durch individuelle Regionen eines zweiten Leitfähigkeitstyps (14) gebildet werden, die wiederum von individuellen Oberflächenregionen des ersten Typs (16) bedeckt werden, die mit einem Referenzpotential der aktiven Schicht verbunden sind, wobei die Gitter eine Dissymmetrie zwischen einer stromaufwärtigen Seite und einer stromabwärtigen Seite aufweisen, auf einer Seite benachbart mit einer Fotodiode und auf der anderen Seite versehen mit schmalen Gitterfingern (20), die in Richtung einer anderen Fotodiode verlaufen, wobei die schmalen Finger durch mit dem ersten Leitfähigkeitstyp dotierte Isolierregionen (18) voneinander getrennt sind, die stärker dotiert sind als die Oberflächenregionen, wie diese verbunden mit dem Referenzpotential der aktiven Schicht, wobei der Sensor **dadurch gekennzeichnet ist, dass** er wenigstens zwei unabhängige Gitter (G2Aᵢ, G2Bᵢ) beinhaltet, gleichzeitig benachbart mit einer zu einer ersten Fotodiodenleitung gehörenden ersten Fotodiode (PH1ᵢ) und einer zu einer zweiten Fotodiodenleitung gehörenden zweiten Fotodiode (PH2ᵢ), wobei die schmalen Finger eines ersten der beiden Gitter in Richtung der ersten Fotodiode verlaufen und die schmalen Finger des zweiten Gitters in Richtung der zweiten Fotodiode verlaufen, und wobei die beiden Gitter separat voneinander gesteuert werden können.

2. Sensor nach Anspruch 1, **dadurch gekennzeichnet, dass** er Mittel zum Anlegen einer Folge von Potentialen an die ersten Gitter umfasst, die das Speichern und Übertragen von Ladungen unter den ersten Gittern zulassen, während das Potential der zweiten Gitter während eines Ladungsintegrationszyklus auf einem festen Wert gehalten wird, während das Speichern und Übertragen von Ladungen unter den zweiten Gittern verhindert wird, und Mittel zum Umkehren der Rollen der ersten und zweiten Gitter, d.h. Anlegen einer Folge von Potentialen an die zweiten Gitter, während das Potential der ersten Gitter auf einem festen Wert gehalten wird.

3. Sensor nach Anspruch 2, **dadurch gekennzeichnet, dass** die Folge von an ein erstes oder ein zweites Gitter angelegten Potentialen das Anlegen eines Potentials beinhaltet, das das Speichern von Ladungen unter dem Gitter während einer ersten Integrationsperiode (Tᵢₙₜ/2), dann das Anlegen eines kurzen Impulses an bestimmte Gitterlinien untersagt, der unter diesen Gittern einen Potentialtopf erzeugt, der die Freisetzung von Ladungen von den dem Gitter benachbarten Fotodioden bis unter das Gitter zulassen.

4. Sensor nach einem der Ansprüche 1 bis 3, **dadurch gekennzeichnet, dass** die beiden dissymmetrischen Gitter nebeneinander in Richtung der Leitungen platziert sind.

5. Sensor nach einem der Ansprüche 1 bis 4, **dadurch gekennzeichnet, dass** das zweite Gitter in zwei Teile unterteilt ist, die geometrisch auf beiden Seiten des ersten Gitters platziert und zum gleichzeitigen Steuern elektrisch miteinander verbunden sind.

6. Sensor nach Anspruch 5, **dadurch gekennzeichnet, dass** jedes der beiden Gitter in wenigstens zwei mit den Teilen des anderen Gitters abwechselnde Teile unterteilt ist, wobei die Teile von einem Gitter elektrisch miteinander verbunden sind, wobei jeder Teil wenigstens einen schmalen Finger umfasst.

7. Bildsensor nach einem der Ansprüche 1 bis 6, **dadurch gekennzeichnet, dass** er ein Sensor zum Abziehen und Integrieren von Ladungen im Hinblick auf eine Beobachtung einer selben Bildleitung aufeinander folgend durch mehrere Pixelleitungen mit einer Summierung von elektrischen Ladungen ist, die von einem Bildpunkt in den Pixeln desselben Rangs von unterschiedlichen Leitungen erzeugt werden, wobei die durch Beleuchten eines Pixels von Rang i während einer Integrationsdauer erzeugten Ladungen sich zu den Ladungen addieren, die von den Pixeln des vorherigen oder nachfolgenden Rangs zu Beginn dieser Dauer empfangen werden.

8. Bildsensor nach einem der Ansprüche 1 bis 7, **dadurch gekennzeichnet, dass** er eine rechteckige Mikrolinse umfasst, die jeweils auf jeder der Fotodioden zentriert ist und das oberhalb eines Teils der der Fotodiode benachbarten Gitter empfangene Licht zu der Fotodiode leitet.

9. Bildsensor nach einem der Ansprüche 1 bis 7, **dadurch gekennzeichnet, dass** er oberhalb jeder Fotodiode wenigstens zwei nebeneinander liegende quadratische Mikrolinsen umfasst, die einen oberhalb der Fotodiode zentrierten Satz bilden und das oberhalb der Fotodiode und oberhalb eines Teils der der Fotodiode benachbarten Gitter empfangene Licht zu der Fotodiode leiten.

## Claims

1. An image sensor using charge transfer, the sensor comprising rows of photodiodes alternating with rows of gates adjacent to the photodiodes, the gates covering a semiconductor active layer region (12) of a first type of conductivity and the photodiodes being formed in the active layer by individual regions of a second type of conductivity (14), themselves covered by individual superficial regions of the first type (16) connected to a reference potential for the active layer, the gates exhibiting an asymmetry between an upstream side and a downstream side, adjacent on one side to a photodiode and having, on the other side, narrow gate fingers (20) extending toward another photodiode, the narrow fingers being separated from one another by insulating regions (18) doped with the first type of conductivity, more doped than the superficial regions and also connected to the reference potential of the active layer, the sensor being **characterized in that** it comprises at least two independent gates (G2Aᵢ, G2Bᵢ), adjacent to both a first photodiode (PH1ᵢ) belonging to a first row of photodiodes and to a second photodiode (PH2ᵢ) belonging to a second row of photodiodes, a first of the two gates having its narrow fingers extending toward the first photodiode and the second gate having its narrow fingers extending toward the second photodiode, and the two gates being controllable separately from each other.

2. The sensor as claimed in claim 1, **characterized in that** it comprises means for applying to the first gates a sequence of potentials allowing the storage and the transfer of charges under the first gates, while at the same time maintaining the potential of the second gates at a fixed value during one charge integration cycle, preventing the storage and the transfer of charges under the second gates, and means for reversing the roles of the first and second gates, in other words applying a sequence of potentials to the second gates while at the same time maintaining the potential of the first gates at a fixed value.

3. The sensor as claimed in claim 2, **characterized in that** the sequence of potentials applied to a first or a second gate comprises the application of a potential prohibiting the storage of charges under the gate during a first integration period (Tᵢₙₜ/2), then the application of a short pulse to certain rows of gates creating under these gates a potential well allowing the discharge of charges from the photodiodes adjacent to the gate as far as under the gate.

4. The sensor as claimed in one of claims 1 to 3, **characterized in that** the two asymmetric gates are placed side by side in the direction of the rows.

5. The sensor as claimed in one of claims 1 to 4, **characterized in that** the second gate is divided into two parts placed geometrically on either side of the first gate and electrically connected together so as to be controlled simultaneously.

6. The sensor as claimed in claim 5, **characterized in that** each of the two gates is divided into at least two parts alternating with the parts of the other gate, the parts of a gate being electrically connected together, each part comprising at least one narrow finger.

7. The image sensor as claimed in one of claims 1 to 6, **characterized in that** it is a time-delay charge integration sensor, with a view to a successive observation of the same image line by several rows of pixels with a summing of the electrical charges generated by an image dot in the pixels of same rank of the various rows, the charges generated by the illumination of a pixel of rank i during one integration period being added to the charges received from the pixel of preceding or following rank at the start of this period.

8. The image sensor as claimed in one of claims 1 to 7, **characterized in that** it comprises a respective rectangular microlens centered on each of the photodiodes and directing toward the photodiode the light received on top of a part of the gates adjacent to the photodiode.

9. The image sensor as claimed in one of claims 1 to 7, **characterized in that** it comprises, on top of each photodiode, at least two juxtaposed square microlenses forming an assembly centered above the photodiode and directing toward the photodiode the light received on top of the photodiode and on top of a part of the gates adjacent to the photodiode.
